# DEMANDE DE BREVET EUROPEEN

(11) **EP 0 837 409 A1**
(43) Date de publication de la demande: **22.04.1998**
(21) Numéro de dépôt: 97402347.5
(22) Date de dépôt: 06.10.1997
(51) Int. Cl.: G06F 17/50

(54) **Procédé d'analyse de structures complexes et système permettant de mettre en oeuvre un tel procédé**

(30) Priorité: 09.10.1996 FR 9612317
(71) Demandeur: BULL S.A., 78430 Louveciennes (FR)
(72) Inventeur: Guignet, Jean-Bruce, 78340 Les Clayes sous Bois (FR); Barbier, Denis, 78113 Adainville (FR)

(57) **Abrégé**

Pour assurer la conformité d'une structure à sa spécification d'origine pour régénérer une structure en fonction d'évolutions technologiques ou pour comparer une structure à une autre structure connue, un procédé d'analyse d'ensemble de structure physique (21) comporte une étape (16) effectuant des opérations ensemblistes sur des sous ensembles de la structure et une visualisation de ces sous ensembles sous forme statistique, structurelle ou fonctionnelle. Un système informatique comprenant une unité mémoire (1), une unité mémoire (2) et un outil d'abstraction (14) accédant en lecture à l'unité mémoire (1) pour remplacer l'accès au données dans une première zone (MEMA) de l'unité mémoire (2) par un accès à de nouvelles données regroupant les données de l'unité mémoire (2), comprend:
- une interface graphique (7) pour visualiser les données accédées dans la première zone (MEMA) ainsi que des données accédées dans une deuxième zone (MEMB) et dans une troisième zone (MEMC) de l'unité mémoire (2);
- une interface opérateur (5) pour commander l'interface graphique (7); et
- des premiers moyens de traitement (8) commandés par l'interface graphique (7) pour effectuer des opérations ensemblistes sur les données accédées dans les zones (MEMA, MEMB, MEMC) et transférer le résultat des dites opérations ensemblistes dans l'une des zones (MEMA, MEMB, MEMC) de l'unité mémoire (2).

## Description

Le domaine d'application de l'invention est celui de l'analyse de structures physiques complexes telles que par exemple des circuits intégrés. Cette analyse est particulièrement utile pour identifier les constituants d'une structure, pour s'assurer de la conformité d'une structure à sa spécification d'origine, pour régénérer une structure en fonction d'évolutions technologiques ou pour comparer une structure à une autre structure connue.

Un constructeur de circuits électriques doit parfois assurer la fourniture de ses produits sur des durées assez longues, par exemple comme pièces de rechanges d'équipements coûteux. Le maintien en stock de tels circuits n'est pas économique, de plus des circuits stockés peuvent vieillir et il est préférable de disposer de pièces de rechange neuves au fur et à mesure des besoins. D'autre part, l'entretien d'un stock surabondant pour la maintenance de ces équipements peut s'avérer inutile. C'est pourquoi, un constructeur est parfois amené à refabriquer des circuits qu'il avait mis au point dans le passé. Pour des circuits intégrés, il dispose de fichiers informatiques archivés décrivant des masques qu'il retransmet à un fondeur de matériaux semi-conducteurs. Cependant, ces masques peuvent s'avérer obsolètes pour différentes raisons d'évolution technologique. Il est alors nécessaire de générer des masques utilisables dans les technologies présentes. Les outils actuels de C.A.O. (conception assistée par ordinateur) permettent de générer des descriptions de masques à partir de spécifications formelles. Ces spécifications formelles, stockées dans des fichiers informatiques, décrivent le comportement fonctionnel attendu des circuits à réaliser.

Le problème est que le constructeur ne possède pas nécessairement de spécifications formelles directement utilisables par les outils de C.A.O. actuels pour refabriquer des circuits dont le comportement soit identique à celui des circuits initiaux. Les raisons sont multiples, le langage de description peut ne pas être adapté aux outils de C.A.O. disponibles, le comportement décrit formellement peut ne pas correspondre rigoureusement à celui du circuit effectivement réalisé à cause d'interventions humaines à différentes étapes de la conception des masques, optimisations ou modifications à la suite de tests. Pour ces diverses raisons, les fichiers de description de masques représentent de façon plus fiable les circuits réalisés, tant sur le plan structurel que fonctionnel.

Cependant, ils ne permettent pas de générer directement de nouvelles descriptions de masques utilisables par les technologies de fabrication au moment d'une relance en fabrication. D'autre part, les descriptions de masques posent des difficultés de compréhension à l'être humain des fonctionnalités du circuit réalisé. Or cette compréhension peut lui être nécessaire pour adapter le circuit aux technologies du moment. Une description formelle lui facilite alors l'analyse du circuit réalisé.

Le constructeur peut posséder dans ses archives, des listes de connectique (netlist en anglais) qui énumèrent les différents éléments du circuit avec leurs interconnexions et éventuellement leur position physique tels qu'ils figurent dans les fichiers de description de masques. Ces listes de connectique ont souvent été générées en parallèle avec la génération des masques existants. Si le constructeur ne possède pas de listes de connectique, certains outils connus sous le nom d'extracteur, permettent de générer des listes de connectique à partir des fichiers de description de masques. Toutefois ces listes de connectique représentent des structures complexes dont la compréhension et l'analyse directe par des moyens connus, sont difficiles voire impossible.

Il est alors utile de pouvoir générer des descriptions structurelle et comportementale d'un circuit existant, sous forme de spécification formelle tant pour être exploitée par des outils de C.A.O. que pour faciliter à l'être humain la compréhension fonctionnelle du circuit existant.

Un constructeur peut également souhaiter faire évoluer les performances d'un circuit lui appartenant en modifiant certaines de ses fonctions ou la technologie de certains de ses éléments. L'enchevêtrement des différents composants du circuit nécessite de sa part certaines précautions pour éviter que les modifications aient des conséquences néfastes sur le comportement global du circuit. Il lui est alors utile de disposer d'un procédé de reconnaissance de circuit pour générer de nouveaux masques. Il peut aussi souhaiter inclure dans un circuit existant certains composants d'autres circuits lui appartenant et dont il connaît les effets. Il lui est alors utile de disposer d'un procédé de reconnaissance de circuit pour retrouver ces composants dans les autres circuits existants afin de générer de nouveaux masques.

On ne rencontre pas uniquement des structures complexes dans le domaine des circuits intégrés mais aussi dans d'autres domaines techniques tel que par exemple la chimie organique. Des molécules complexes peuvent résulter de leur fabrication par l'homme mais aussi de processus naturels tels que biologiques. Il est possible de répertorier aujourd'hui dans des fichiers informatiques, de nombreuses séquences de nucléotides et d'acides aminés dont on connaît certains effets. Face à des représentations de séquences inconnues mais dont les effets de certaines sous séquences peuvent être connues, il est intéressant d'utiliser l'invention pour reconnaître de nouvelles séquences. La liste de connectique est alors représentée par la représentation de séquence en vue d'obtenir une spécification d'effets produits par cette séquence.

La demande de brevet français 9410260 déposée le 24 Août 1994 au nom du demandeur décrit un outil produisant de façon automatique une spécification abstraite d'un système physique à partir d'un descriptif concret définissant la structure de ce système.

Cependant, dans l'analyse de la structure d'un système physique, on ne souhaite pas nécessairement obtenir une spécification abstraite de la totalité mais seulement d'une partie de cette structure physique, en fonction d'intérêts spécifiques. Or il est souvent difficile d'extraire une partie d'une structure dont la complexité engendre un enchevêtrement de ses éléments, tant dans leur localisation que dans leurs interactions. Pour une structure complexe comprenant un nombre considérable d'éléments, le descriptif concret se présente sous forme d'un ensemble de données informatiques.

Pour pallier ce problème, l'invention concerne un procédé d'analyse d'un ensemble de données informatiques contenant une liste de connectique pour décrire une structure physique, caractérisé en ce qu'il comporte une première étape effectuant des opérations ensemblistes sur des sous ensembles de l'ensemble de données informatiques et une visualisation de ces sous ensembles sous forme statistique, structurelle, schématique, électrique ou fonctionnelle.

Cependant, il peut arriver qu'une partie, même restreinte, de structure conserve un niveau de complexité élevé. Il peut arriver aussi qu'une description structurelle ne suffise pas à effectuer une migration technologique qui nécessite une spécification fonctionnelle.

Pour pallier ces problèmes supplémentaires, l'invention concerne aussi un procédé d'analyse caractérisé en ce qu'il comporte une première étape d'abstraction structurelle et fonctionnelle pour générer un ensemble de données informatiques fonctionnelles et structurelles.

D'autre part, si régénérer une structure physique à l'aide de seules méthodes manuelles et intellectuelles s'avère difficile, le faire de façon purement automatique risque de poser des problèmes de conformité entre la structure réalisée et la structure escomptée. Une procédure automatique ne permet pas de réaliser certaines structures.

Pour cela le procédé permet d'effectuer, en cours d'analyse, une répartition entre ce qui peut être réalisé automatiquement et ce qui nécessite une intervention manuelle. L'invention concerne encore un procédé d'analyse caractérisé en ce que la dite première étape pilote une étape de synthèse automatique générant, à partir de l'ensemble de données informatiques abstraites, un ensemble de données informatiques concrètes pour régénérer une structure physique.

On ne dispose pas toujours des connaissances nécessaires pour effectuer une abstraction fonctionnelle et structurelle d'une structure physique à priori inconnue.

Pour cela, l'invention concerne encore un procédé d'analyse caractérisé en ce que la dite première étape génère un ensemble de données informatiques contenant des connaissances pour piloter l'étape d'abstraction structurelle et fonctionnelle.

Pour mettre plus particulièrement en oeuvre un procédé conforme à l'invention, l'invention concerne aussi un système informatique comprenant un outil d'abstraction, une première unité mémoire destinée à contenir des données pour paramètrer et piloter l'outil d'abstraction, une deuxième unité mémoire destinée à contenir des données à transformer par l'outil d'abstraction, accessibles dans une première zone de la deuxième unité mémoire, caractérisé en ce qu'il comprend:
- une interface graphique pour visualiser les données accédées dans la première zone ainsi que des données accédées dans une deuxième zone et dans une troisième zone de la deuxième unité mémoire;
- une interface opérateur pour commander l'interface graphique; et
- des premiers moyens de traitement commandés par l'interface graphique pour effectuer des opérations ensemblistes sur les données accédées dans les première, deuxième et troisième zones et transférer le résultat des dites opérations ensemblistes dans l'une des dites zones de la deuxième unité mémoire.

Un exemple particulier de mise en oeuvre de l'invention est décrit en référence aux figures.
- La figure 1 est une représentation globale d'un procédé de régénération de structures complexes.
- La figure 2 est une représentation d'un système conforme à l'invention.

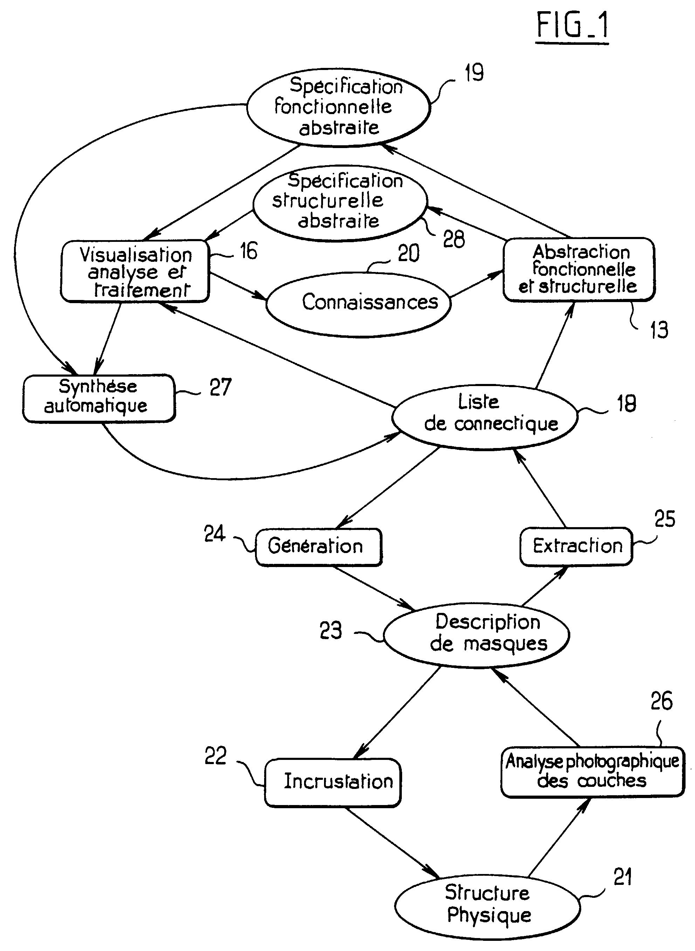

Selon la figure 1, un ensemble de données informatiques 18 contient une liste de connectique qui décrit une structure physique 21 de nature complexe. A titre d'exemples de structures physiques 21, on peut citer de façon non exhaustive, des macromolécules dans le domaine de la chimie organique ou des circuits intégrés dans le domaine de l'électronique. Dans le cas de macromolécules, la liste de connectique contient une liste d'atomes constituant cette macromolécule et une liste de liaisons de covalence entre ces atomes.

Dans le cas particulier de circuits intégrés, la liste de connectique contient une liste de composants notés COMPOSANT constituant le circuit et une liste de connexions entre ces composants. Parmi les composants, on distingue des primitives notées PRIMITIVE (transistors, résistances, diodes) et des entités notées ENTITE (portes logiques élémentaires, inverseurs). Généralement, la structure physique 21 est obtenue ici par une étape d'incrustation 22 dans des matériaux semi-conducteurs à partir d'une description de masques 23, elle-même obtenue par une étape de génération 24 à partir de la liste de connectique contenue dans l'ensemble de données informatiques 18. En l'absence de liste de connectique 18, on peut envisager de l'obtenir à partir de la description de masques 23 par une étape d'extraction 25. En l'absence de description de masques 23, on peut envisager de l'obtenir par une étape d'analyse photographique 26 des couches de matériaux semi-conducteurs constituant le circuit intégré.

Une étape 16 analyse la liste de connectique et opère des sélections en effectuant des opérations ensemblistes sur différents sous ensembles de l'ensemble de données informatiques 18. Pour faciliter cette phase d'analyse et de sélections, l'étape 16 peut prévoir une visualisation de ces sous ensembles de différentes manières, par exemple sous forme de liste de connectique réduite ou sous forme de données statistiques élaborées à partir de l'ensemble de données 18 ou à partir d'un ensemble de données informatiques 28 contenant une spécification structurelle abstraite. On prévoit encore une visualisation de ces sous ensembles sous forme de spécifications fonctionnelles abstraites obtenues à partir d'un ensemble de données informatiques 19. L'étape 16 permet par exemple de transformer les données sélectionnées en les traitant automatiquement par un convertisseur de format et manuellement par un éditeur de texte.

Les ensembles de données informatiques 19 et 28 résultent d'une étape d'abstraction fonctionnelle et structurelle sur l'ensemble de données informatiques 18.

L'étape 16 est encore prévue pour élaborer un ensemble de données informatiques 20 décrivant des connaissances pour piloter l'étape d'abstraction 13. Une étape de synthèse automatique 27 permet d'élaborer un ensemble de données informatiques 18 contenant une nouvelle liste de connectique. Cette nouvelle liste de connectique permet de régénérer une nouvelle structure physique 21 en passant par les étapes 22 et 24.

Un intérêt supplémentaire de l'étape 16 est procuré par ses interactions possibles avec l'étape 27.

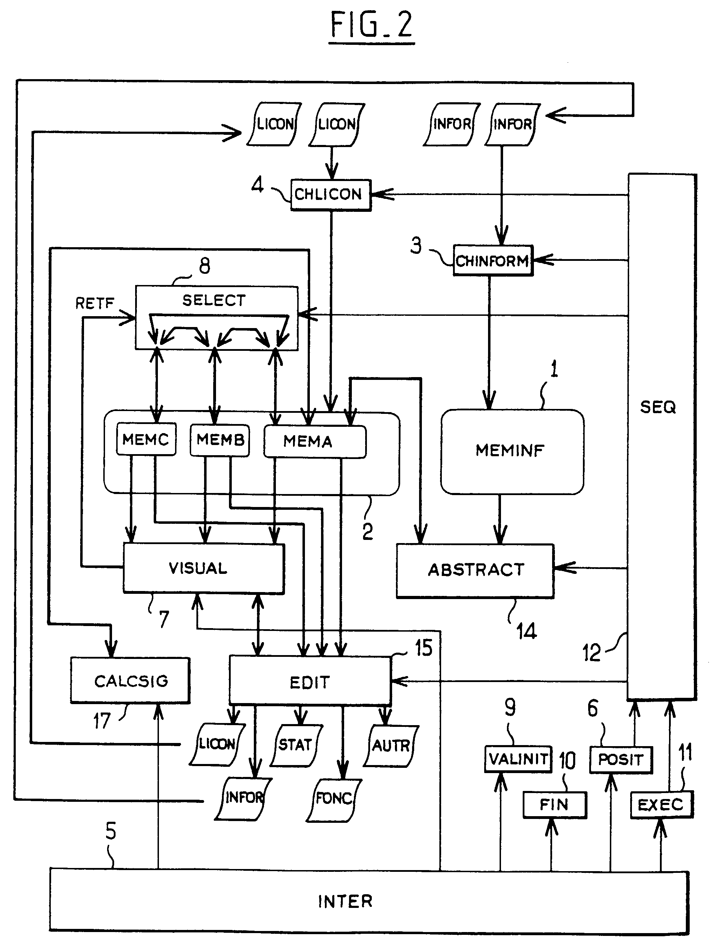

La figure 2 présente l'architecture d'un système permettant de mettre en oeuvre l'invention. Une unité mémoire 1 est accessible en écriture à une interface d'entrée 3 pour y stocker des connaissances en provenance d'un ou plusieurs fichiers contenant de l'information présentée dans un format INFOR donné. L'interface d'entrée 3, commandée par un séquenceur 12, agence l'information présentée sous forme de connaissances directement exploitables par le système au moyen d'une fonction pré programmée CHINFORM. Une unité mémoire 2 est accessible en écriture à une interface d'entrée 4 pour y stocker des données en provenance d'un ou plusieurs fichiers contenant une description de structure physique présentée dans un format LICON donné. L'interface d'entrée 4, commandée par le séquenceur 12, agence la description présentée sous forme de données directement exploitables par le système au moyen d'une fonction pré programmée CHLICON en particulier, la fonction CHLICON rend les données accessibles dans une zone d'adressage MEMA de l'unité mémoire 2. Un outil d'abstraction 14 accède en lecture à l'unité mémoire 1 au moyen d'une zone d'adressage MEMINF de l'unité mémoire 1. L'outil d'abstraction 14 accède en lecture et en écriture à l'unité mémoire 2 au moyen de la zone d'adressage MEMA de l'unité mémoire 2. L'outil d'abstraction 14, commandé par le séquenceur 12, traite les données de l'unité mémoire 2 en exécutant une procédure d'abstraction pré programmée ABSTRACT au moyen de connaissances lues dans l'unité mémoire 1.

La procédure d'abstraction ABSTRACT exécute une succession d'étapes telles que chaque étape consiste à remplacer, dans la zone MEMA, l'accès aux données décrivant des éléments physiques par un accès à de nouvelles données décrivant des composants physiques qui regroupent les dits éléments physiques. Les nouvelles données décrivant des composants physiques sont créées par l'outil d'abstraction 14 à partir des connaissances contenues dans l'unité mémoire 1, par exemple en utilisant les moyens décrits dans la demande de brevet FR2724031. L'outil d'abstraction 14 range les nouvelles données créées dans l'unité mémoire 2 au moyen de la zone d'adressage MEMA. L'ensemble des composants physiques résultant d'une étape et l'ensemble des éléments physiques non regroupés à une étape constituent un ensemble d'éléments physiques pour l'étape suivante.

Avant exécution de la procédure d'abstraction, les données décrivant des éléments physiques sont essentiellement de types structurel et physique. Dans l'exemple d'éléments physiques qui sont des primitives de circuit intégré tels que transistors, diodes, résistances, les données de type structurels sont constituées d'une liste des primitives et des connexions entre ces primitives (liste de connectique) et les données de type physiques sont constituées pour chaque primitive de listes de paramètres tels que par exemple en technologie MOS, la largeur et la longueur de grille, les coordonnées de la position du transistor dans le circuit. L'exécution de la procédure d'abstraction génère de nouvelles données de types structurel et physique. En mettant à profit l'enseignement de la demande de brevet FR2724031, l'exécution de la procédure d'abstraction peut générer aussi des données de type comportemental, exprimables sous forme d'une spécification formelle.

En plus de la zone d'adressage MEMA, l'unité mémoire 2 contient deux zones d'adressage MEMB et MEMC. Les zones MEMA, MEMB et MEMC sont accessibles en lecture et écriture à des moyens de traitement 8 exécutant différentes opérations ensemblistes sur les zones MEMA, MEMB et MEMC à l'aide d'une fonction SELECT commandée par le séquenceur 12. On distingue essentiellement deux types d'opérations ensemblistes, les opérations de type TRANSF et les opérations de type FILTR. Les opérations de type TRANSF transfèrent, sur commande de l'utilisateur dans le cas d'une intervention manuelle, soit une zone MEMA, MEMB ou MEMC vers l'une des deux autres zones MEMA, MEMB ou MEMC, soit l'union, l'intersection ou la différence ensembliste de deux zones dans l'une de ces deux zones ou vers une troisième zone, soit encore le complément ensembliste d'une zone par rapport à une autre zone dans l'une de ces deux zones ou vers une troisième zone. Les opérations de type FILTR réduisent une zone d'adressage MEMA, MEMB ou MEMC pour filtrer l'accès à certaines données de l'unité mémoire 2 en fonction de critères, à titre d'exemple non limitatif, tels que physiques, topologiques, logiques ou électriques. Avantageusement, ces critères sont définis interactivement par l'utilisateur. Une zone d'adressage peut être réduite jusqu'à l'ensemble vide.

Le résultat d'une opération ensembliste dans la zone d'adressage MEMA donne alors accès à un sous ensemble des données initialement accessibles par la zone d'adressage MEMA. Nous verrons par la suite différents avantage d'un tel résultat mais nous pouvons citer dès à présent celui de limiter une abstraction, effectuée au moyen de l'outil 14, aux seuls éléments décrits par les données accessibles dans la zone d'adressage MEMA.

Les données de l'unité mémoire 2, accessibles par l'une des zones d'adressage MEMA, MEMB ou MEMC, le sont en lecture à des moyens de traitement 15 pour générer des fichiers de différents formats tels que par exemple LICON, FONC et AUTR, au moyen de fonctions d'édition EDIT.

L'édition d'un fichier de format LICON permet d'obtenir une liste de connectique, par exemple sur une partie de structure physique limitée aux seuls éléments décrits par les données accessibles dans l'une des zones d'adressage MEMA, MEMB ou MEMC. Ceci présente l'avantage d'extraire un sous ensemble de structure physique pour l'analyser plus facilement ou pour l'intégrer directement dans une autre structure physique. Si les données résultent d'abstractions effectuées par l'outil 14, l'édition du fichier de format LICON facilite l'analyse de la structure physique décrite. Le fichier de format LICON peut être utilisé par des systèmes de génération de schémas automatiques ou être réintroduit ultérieurement dans l'interface d'entrée 4 pour être traité à nouveau par le système de l'invention.

Un fichier de format FONC est destiné à contenir un ensemble de descriptions fonctionnelles de structures complexes décrites par des données contenues dans une zone MEMA, MEMB ou MEMC de l'unité mémoire. Les descriptions fonctionnelles sont du type de celle obtenues à l'aide de l'outil 14 tel que décrites dans la demande de brevet FR9410260. Une description fonctionnelle réduite à un sous ensemble d'une structure de départ en facilite la compréhension et permet d'introduire cette description fonctionnelle dans une autre description fonctionnelle pour générer une nouvelle structure physique. Il est toujours possible d'obtenir une description fonctionnelle complète pour effectuer simplement une migration technologique.

Un fichier de format AUTR est destiné à contenir par exemple un ensemble de descriptions structurelles, fonctionnelles, électriques ou autres selon divers formats standards adaptés à leur exploitation éventuelle par d'autres systèmes.

Les données de l'unité mémoire 2, accessibles par l'une des zones d'adressage MEMA, MEMB ou MEMC, le sont en lecture à une interface graphique 7 pour effectuer une fonction de visualisation VISUAL et pour générer des signaux de rétroaction fonctionnelle RETF à destination des moyens de traitement 8. L'interface 7 est reliée d'une part à un écran non représenté pour y afficher des résultats de la fonction VISUAL et d'autre part à une interface de commande utilisateur 5 qui permet à un opérateur humain d'agir sur la fonction VISUAL par des moyens connus tels qu'un clavier ou une souris, non représentés.

La fonction VISUAL consiste à afficher sur l'écran les données contenues dans les zones MEMA, MEMB ou MEMC au moyen de fenêtres, dédiées chacune à une mémoire particulière et de marquer dans une ou plusieurs fenêtres des données sélectionnées au moyen de l'interface 5. L'affichage dans une fenêtre des données d'une zone MEMA, MEMB ou MEMC peut se faire dans différents modes graphiques nommés VUEGRAPH ou texte nommés VUETEXT, commandés par l'interface 5. Comme exemple de modes graphique, on peut citer un mode nommé VUEPHY qui affiche une vue physique décrivant des tracés de masques à l'origine des données affichées, un mode nommé VUECONTOUR qui affiche une vue décrivant des contours topologiques de composants reconnus par le système, un mode nommé VUESCHEMA qui affiche une vue décrivant un schéma électrique construit à partir de signaux et de composants. Comme exemple de modes texte, on peut citer un mode nommé LISIG qui affiche une liste de noms de signaux, un mode nommé LITYPE qui affiche une liste de composants d'un type donné, un mode nommé LIRESIDUEL qui affiche une liste de composants résiduels non reconnus par le système. Un avantage de la fonction VISUAL est de permettre le passage d'un mode d'affichage à un autre dans une fenêtre par simple commande transmise au moyen de l'interface 5.

L'interface 7 comprend des moyens pour afficher différents types de vues telles que physique, topologique, logique, schématique ou autre et des moyens pour pointer dans l'une quelconque de ces vues sur n'importe quelle description graphique ou textuelle de façon à localiser la description qui lui correspond dans une autre vue. En pointant par exemple sur un élément topologique, on obtient des références croisées qui permettent aux vues des fenêtres physiques et schématiques de s'illuminer ou de se centrer sur les descriptions physiques ou schématiques correspondantes.

L'interface 7 génère des signaux de rétroaction fonctionnelle RETF pour commander les moyens de traitement 8 de façon à y effectuer différentes opérations ensemblistes de la fonction SELECT. Les signaux de rétroaction fonctionnelle résultent d'interactions de l'opérateur humain sur l'une des vues précédemment décrites au moyen de l'interface 5. L'interface 7 permet une convivialité notable dans la commande des moyens de traitement 8 par un opérateur humain.

Un aspect intéressant des moyens de traitement 15 est dans la génération de fichiers de connaissances de format INFOR qui peuvent être réintroduits dans le système au moyen de l'interface 3 pour enrichir les connaissances contenues dans l'unité mémoire 1. La génération du fichier de données de format INFOR se fait au moyen de fonctions d'édition EDIT, à partir du contenu d'une zone MEMA, MEMB ou MEMC de l'unité mémoire 2 de la façon que nous décrivons à présent.

Pour générer des données de type INFOR, les moyens de traitement 15 utilisent les données de format LICON contenus par exemple dans la zone MEMB de l'unité mémoire. Les données de format LICON décrivent des éléments de deux types principaux, les éléments de type COMPOSANT et les éléments de type CONNECT. Dans le cas d'un circuit électronique, les éléments de type COMPOSANT sont par exemple des transistors ou des groupements de transistors et les éléments de type CONNECT sont les connections entre ces transistors ou entre ces groupements de transistors et les connections ouvertes de ces transistors ou groupements de transistors avec l'extérieur du circuit électronique. Les données de type INFOR décrivent des connaissances permettant de piloter l'outil d'abstraction 14. Des connaissances peuvent être décrites par exemple au moyen de formalismes utilisant des langages de description structurelle ou des langages de règles de production. La prémisse d'une règle est constituée de données et de variables libres décrivant un modèle et la conclusion est constituée de données et de variables libres décrivant le modèle à un niveau d'abstraction plus élevé. Pour décrire le modèle à un niveau d'abstraction plus élevé, les éléments de type COMPOSANT intervenant dans le modèle sont remplacés par un unique élément de type COMPOSANT et les éléments de type CONNECT sont remplacés par les seuls éléments de type CONNECT partagés par des éléments extérieurs au modèle. La description à un niveau d'abstraction plus élevé est constituée d'un ensemble de données structurelles, et éventuellement d'un ensemble de données fonctionnelles.

En se référant à l'exemple du système avec règles de production, les moyens de traitement 15 créent un modèle en recopiant les données décrivant les éléments de type COMPOSANT et en remplaçant les données décrivant les éléments de type CONNECT par des variables libres. Les moyens de traitement 15 chargent ensuite le modèle ainsi créé dans la prémisse d'une règle. Parallèlement, les moyens de traitement 15 affichent à l'écran une fenêtre REGLE au moyen de l'interface de visualisation 7.

Le contenu de la fenêtre REGLE est constituée par exemple de lignes de texte organisées en différents champs délimités par des mots clé. Un premier champ contient un nom de règle proposé par défaut par les moyens 15. Un deuxième champ reconnu par exemple au moyen d'un mot clé "SI" et éventuellement de mots clé "AVEC" contient la prémisse de la règle décrivant le modèle créé. Un troisième champ reconnu par exemple au moyen d'un mot clé "FAIRE", contient un nom de composant proposé par défaut par les moyens 15, un sous champ structurel reconnu par exemple au moyen d'un mot clé "STRUCTURE" et éventuellement un sous champ fonctionnel reconnu par exemple au moyen d'un mot clé "FONCTION". Les sous champs structurels et fonctionnels peuvent être remplis de lignes de texte proposées par défaut ou laissés libres. Il est possible de modifier au moyen des interfaces 5 et 7, tout ou partie du texte affiché dans la fenêtre REGLE. Le nom de règle et le nom de composant peuvent être remplacés par des mots plus parlant que ceux proposés par défaut. Le modèle peut être modifié pour mieux cibler un composant recherché. Il est possible d'écrire dans le sous champ structurel une description dans un langage connu tel que, à titre non limitatif EDIF ou VHDL structurel. Il est possible d'écrire dans le sous champ fonctionnel une description dans un langage connu tel que, à titre non limitatif VERILOG ou VHDL comportemental. De façon générale, des modèles de circuits sont mis en forme à partir de structures pour piloter le procédé d'abstraction.

Un autre aspect intéressant des moyens de traitement 15 est dans la génération de fichiers statistiques de format STAT destinés à contenir des données chiffrées sur la nature et la quantité d'éléments décrits par les données contenue dans une zone MEMA, MEMB ou MEMC de l'unité mémoire. A partir de chaque groupe de données décrivant un élément, des moyens de traitement 17 exécutent une fonction CALCSIG pour calculer une ou plusieurs signatures de cette élément. Par exemple, si les éléments sont des composants électroniques constitués de transistors, le calcul de la signature se fait par une succession de traitements arithmétiques sur les dimensions de ces transistors et sur les coordonnées de leurs positions relatives. La succession de traitements arithmétiques s'effectue de façon à ce que la valeur de la signature soit un nombre significatif des caractéristiques physiques et topologiques de l'élément décrit par le groupe de données. C'est à dire que tous les éléments et seulement les éléments ayant des caractéristiques physiques et topologiques identiques auront la même signature. Toute méthode de calcul de signature respectant les contraintes évoquées ci-dessus convient sans qu'il soit nécessaire de rentrer ici plus avant dans les détails. Le résultat d'un calcul de signature est rangé dans l'unité mémoire 2 comme attribut de l'élément au moyen de la zone d'adressage MEMA. Ces attributs sont accessibles en lecture par la zone d'adressage MEMA, MEMB ou MEMC, aux moyens de traitement 15 pour éditer un fichier de format STAT. Si le calcul de la signature d'un élément donne une nouvelle valeur, les moyens de traitement 15 créent une structure de données constituée de différents champs dont un premier champ contient une indication du type d'élément décrit, un deuxième champ contient la valeur de la signature et un troisième champ contient une valeur de compteur initialisée à un au moment de la création. Si le calcul de la signature d'un élément donne une valeur contenue dans le deuxième champ d'une structure de données précédemment calculée, les moyens de traitement 15 incrémentent la valeur contenue dans le troisième champ. L'ensemble des structures de données ainsi créées par les moyens de traitement 15 jusqu'à épuisement de toutes les données contenue dans une zone MEMA, MEMB ou MEMC de l'unité mémoire, constitue le fichier de type STAT.

Sur commande de l'interface opérateur 5, les moyens de visualisation 7 accèdent en lecture aux valeurs de signatures contenues dans l'unité mémoire 2 par une zone d'adressage MEMA, MEMB ou MEMC pour afficher dans une fenêtre d'écran, nommée VUEDIAGRAM, une représentation graphique de fichier de type STAT, par exemple sous forme d'un diagramme où sont portés en ordonnée des couples (type, signature) et en abscisse le nombre d'éléments reconnus pour chaque couple. Une telle représentation graphique permet d'analyser la diversité des éléments qui constituent une structure physique complexe telle que par exemple un circuit électrique. Ceci permet aussi de reconnaître précisément la ou les provenances d'éléments à partir desquels la structure complexe a été construite. Le contenu d'un fichier de type STAT peut encore être exploité par le système à d'autres fins telles que par exemple l'affichage en surbrillance ou avec une couleur spéciale d'éléments d'une vue donnée par l'interface 7, ayant même signature. Un fichier de type STAT permet donc de savoir par exemple quels sont les composants d'un circuit électrique qui ont les mêmes propriétés électriques en plus des mêmes propriétés logiques.

L'interface opérateur 5 permet de démarrer le système en rangeant dans un ou plusieurs registres 9 des valeurs d'initialisation VALINIT qui indiquent par exemple des noms de fichier de format LICON et INFOR à traiter par le système, et d'arrêter le système en rangeant dans un ou plusieurs registres 10 des valeurs d'arrêt FIN. Ces valeurs sont affichables à l'écran.

Un registre 6 contient un ensemble d'indicateurs bistables POSIT tels que par exemple P1 pour l'activation de l'interface 3, P2 pour l'activation de l'interface 4, P3 pour l'activation des moyens de traitement 8, P4 pour l'activation de l'outil d'abstraction 14 et P5 pour l'activation des moyens de traitement 15. Les valeurs des indicateurs POSIT sont chargeables à partir de l'interface 5.

A partir des valeurs d'indicateur POSIT, un séquenceur 12 active le système en fonction de données d'exécution contenues dans un ou plusieurs registres 11, chargeables à partir de l'interface 5. Par exemple, P1, P2, P4 et P5 positionnés enclenchent un chargement de fichier INFOR, un chargement de fichier LICON, un traitement par l'outil 14 puis une édition de fichiers LICON et FONC par les moyens de traitement 15.

Le système décrit à l'aide de la figure 2 offre de nombreuses possibilités pour mettre en oeuvre le procédé décrit à l'aide de la figure 1, y compris celle où on dispose par exemple d'une liste de connectique stockée dans un fichier de données informatiques 18 dans un format donné LICON.

La liste de connectique contient une liste de composants et une liste de connections entre ces composants. Les primitives sont des composants élémentaires tels que par exemple, des transistors, des diodes ou des résistances, repérés par leurs types tels que MOSN, MOSP, NPN ou PNP pour des transistors, et décrits par leurs connecteurs tels que grille, drain source pour des transistors de type MOS, par leurs caractéristiques physiques tels que largeur et longueur de grille pour des transistors de type MOS et par leur position géographique dans la structure telles que des coordonnées cartésiennes. Les connexions sont des conducteurs électriques qui relient entre eux des connecteurs de composants (connexions internes) ou qui relient des connecteurs de composants avec l'extérieur de la structure (connexions externe), pour véhiculer par exemple des signaux. Les connexions sont alors repérées par les noms de signaux qu'elles véhiculent.

Au moyen de l'interface opérateur 5 on range dans un registre 9 une valeur d'initialisation VALINIT qui indique le nom de fichier de format LICON à traiter par le système.

Au moyen de l'interface 5, on active une séquence exécutée par le séquenceur 12 qui consiste à ranger le fichier 18 dans l'unité mémoire 2 au moyen de l'interface 4 et à déclencher les moyens de traitement 8.

Au moyen de l'interface de visualisation 7 et de l'interface opérateur 5, on affiche une vue sur un écran du système, une vue des données de l'unité mémoire 2. On repère alors les types de composants élémentaires décrits par ces données de façon à déterminer la technologie de réalisation de la structure.

Si on possède un fichier de connaissances 20 pour la technologie déterminée, on range dans un registre 9, au moyen de l'interface opérateur 5, une valeur d'initialisation VALINIT qui indique le nom de fichier de format INFOR à traiter par le système.

Au moyen de l'interface 5, on active une séquence exécutée par le séquenceur 12 qui consiste à ranger le fichier 20 dans l'unité mémoire 1 au moyen de l'interface 3 et à déclencher l'outil d'abstraction 14 et les moyens de traitement 15.

Si on ne possède pas de fichier de connaissances 20 pour la technologie déterminée ou si les connaissance dont on dispose ne sont pas suffisantes pour obtenir une abstraction souhaitée, on cherche à identifier et à modéliser, grâce à EDIT, les composants décrits par les données de l'unité mémoire 2 dans le mode VUESCHEMA, de façon à introduire de nouvelles connaissances dans le système, apportées par une intervention de l'utilisateur.

Pour cela, au moyen des interfaces 5 et 7 et des moyens de traitement 8, on sélectionne dans la zone d'adressage MEMA, des sous ensembles rendus accessibles dans les zones d'adressage MEMB et MEMC. On effectue des opérations ensemblistes sur les zones MEMA, MEMB et MEMC. A l'aide des moyens de traitement 15, on crée un fichier de connaissance au format INFOR sur les résultats des opérations ensemblistes, puis on charge ce fichier dans l'unité mémoire 1 au moyen de l'interface 3. A l'aide de l'outil d'abstraction 15, on déclenche un nouveau processus d'abstraction puis on répète éventuellement les opérations précédemment décrites jusqu'à obtenir un résultat satisfaisant.

Enfin, on commande aux moyens de traitement 15, l'édition d'un fichier 19 au format FONC pour contenir une spécification fonctionnelle abstraite de la structure analysée.

L'homme du métier appréciera sans difficulté de nombreuses autres possibilités d'utilisation du système de l'invention, telles que par exemple celui de commander aux moyens de traitement 15, l'édition d'un fichier 28 au format LICON pour contenir une spécification structurelle abstraite de la structure analysée.

## Revendications

1. Procédé d'analyse d'un ensemble de données informatiques (18) contenant une liste de connectique pour décrire une structure physique (21) caractérisé en ce qu'il comporte une étape (16) effectuant des opérations ensemblistes sur des sous ensembles de l'ensemble de données informatiques (18) et une visualisation de ces sous ensembles sous forme statistique, structurelle, électrique, schématique ou fonctionnelle.

2. Procédé d'analyse suivant la revendication 1 caractérisé en ce qu'il comporte une étape d'abstraction structurelle et fonctionnelle (13) pour générer un ensemble de données informatiques fonctionnelles (19) et structurelles (28) à partir de l'ensemble de données informatiques (18).

3. Procédé d'analyse suivant la revendication 2 caractérisé en ce que l'étape (16) effectuant des opérations ensemblistes pilote une étape de synthèse automatique (27) générant, à partir de l'ensemble de données informatiques (19), un ensemble de données informatiques (18) pour régénérer une structure physique (21).

4. Procédé d'analyse suivant la revendication 2 caractérisé en ce que l'étape (16) effectuant des opérations ensemblistes génère un ensemble de données informatiques (20) contenant des connaissances pour piloter l'étape (13) d'abstraction structurelle et fonctionnelle.

5. Système informatique comprenant un outil d'abstraction (14), une première unité mémoire (1) destinée à contenir des données pour paramètrer et piloter l'outil d'abstraction (14), une deuxième unité mémoire (2) destinée à contenir des données à transformer par l'outil d'abstraction (14), accessibles dans une première zone (MEMA) de la deuxième unité mémoire (2), caractérisé en ce qu'il comprend:
- une interface graphique (7) pour visualiser les données accédées dans la première zone (MEMA) ainsi que des données accédées dans une deuxième zone (MEMB) et dans une troisième zone (MEMC) de la deuxième unité mémoire (2);
- une interface opérateur (5) pour commander l'interface graphique (7); et
- des premiers moyens de traitement (8) commandés par l'interface graphique (7) pour effectuer des opérations ensemblistes sur les données accédées dans les zones (MEMA, MEMB, MEMC) et transférer le résultat des dites opérations ensemblistes dans l'une des zones (MEMA, MEMB, MEMC) de la deuxième unité mémoire (2).

6. Système informatique selon la revendication 5, caractérisé en ce qu'il comprend des deuxièmes moyens de traitement (15) pour générer, à partir d'une zone (MEMA, MEMB, MEMC), un premier ensemble de données structuré selon un premier format (INFOR) chargeable dans ladite première unité mémoire (1 ) et un deuxième ensemble de données structuré selon un deuxième format (LICON) chargeable dans ladite deuxième unité mémoire (2).

7. Système informatique comprenant une première unité mémoire (1), une deuxième unité mémoire (2), une première interface d'entrée (3) pour ranger dans ladite première unité mémoire (1) un ensemble structuré de données selon un premier format (INFOR), une deuxième interface d'entrée (4) pour ranger dans ladite deuxième unité mémoire (2) un ensemble structuré de données selon un deuxième format (LICON) et un outil d'abstraction (14) accédant en lecture à une zone (MEMINF) de ladite première unité mémoire (1) pour regrouper les données accédées dans une première zone (MEMA) de ladite deuxième unité mémoire (2), caractérisé en ce que ladite deuxième unité mémoire (2) comprend une deuxième zone (MEMB) et une troisième zone (MEMC) pour accéder chacune à un ensemble structuré de données selon le deuxième format (LICON), et en ce qu'il comprend des premiers moyens de traitement (8) pour effectuer des opérations ensemblistes sur les données accédées dans les zones (MEMA, MEMB, MEMC) et transférer le résultat des dites opérations ensemblistes dans l'une des zones (MEMA, MEMB, MEMC) de ladite deuxième unité mémoire (2).

8. Système informatique selon la revendication 7, caractérisé en ce qu'il comprend une interface graphique (7) pour visualiser sur un écran le contenu de ladite deuxième unité mémoire (2) accédées dans les zones (MEMA, MEMB, MEMC) et une interface opérateur (5) pour commander l'interface graphique (7).

9. Système informatique selon la revendication 8, caractérisé en ce qu'il comprend des deuxièmes moyens de traitement (15) pour générer, à partir d'une zone (MEMA, MEMB, MEMC), un premier ensemble structuré de données selon ledit premier format (INFOR) à destination de la première interface (3) et un deuxième ensemble structuré de données selon ledit deuxième format (LICON) à destination de la deuxième interface (4).

10. Système informatique selon la revendication 6 ou 9, caractérisé en ce qu'il comprend un séquenceur (12) pour commander selon une séquence donnée les interfaces (2,3), les moyens de traitement (8), l'outil d'abstraction (14) ou les moyens de traitement (15), à partir de l'interface opérateur (5).

11. Système informatique selon la revendication 6 ou 9, caractérisé en ce qu'il comprend des moyens de traitement (17) pour calculer une ou plusieurs signatures de chaque élément d'un ensemble structuré de données selon ledit deuxième format (LICON) et dont le résultat est accessible aux moyens de traitement (15) pour éditer les nombres cardinaux d'éléments de signatures identiques.

12. Système informatique selon la revendication 8, caractérisé en ce que l'interface (7) comprend des moyens pour afficher différents types de vues telles que physique, topologique, logique, schématique ou autre et des moyens pour pointer dans l'une quelconque de ces vues sur n'importe quelle description graphique ou textuelle de façon à localiser la description qui lui correspond dans une autre vue.
